(19) Europäisches Patentamt
European Patent Office
Office européen des brevets

(11) **EP 4 283 311 A1**

(12) **EUROPÄISCHE PATENTANMELDUNG**

(43) Veröffentlichungstag:
**29.11.2023   Patentblatt 2023/48**

(21) Anmeldenummer: **23164642.3**

(22) Anmeldetag: **28.03.2023**

(51) Internationale Patentklassifikation (IPC):
*G01R 19/00* (2006.01)     *G08B 29/00* (2006.01)
*H04B 3/54* (2006.01)      *B60L 5/18* (2006.01)
*B60L 53/20* (2019.01)     *B60L 3/12* (2006.01)
*B60L 9/00* (2019.01)      *B60L 9/18* (2006.01)

(52) Gemeinsame Patentklassifikation (CPC):
**B60L 5/18; B60L 3/12; B60L 9/005; B60L 9/18;
B60L 53/20; G01R 19/00; G08B 29/00; H04B 3/54;**
B60L 2210/10

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(30) Priorität: **20.05.2022   DE 102022205046**

(71) Anmelder: **Siemens Mobility GmbH
81739 München (DE)**

(72) Erfinder:
• **Baumgartner, Robert
82178 Puchheim/Bhf. (DE)**
• **Seisenberger, Claus
84181 Neufrannhofen (DE)**

(74) Vertreter: **Siemens Patent Attorneys
Postfach 22 16 34
80506 München (DE)**

(54) **STEUERSCHALTUNG, STROMABNEHMER UND FAHRZEUG**

(57)    Die Erfindung betrifft eine Steuerschaltung (100) für einen Stromabnehmer (101) für ein über eine Oberleitung (201) elektrisch antreibbares Fahrzeug (200), umfassend einen Stromabnehmer (101), einen mit dem Stromabnehmer (101) verbundenen Umrichter (103) mit einem Anschlusselement (105) zum Anschließen an einen Antriebsstrang (107) des Fahrzeugs (200), eine zwischen Stromabnehmer (101) und Umrichter (103) verschaltete Drosselspule (109), ein parallel zur Drosselspule (109) verschaltetes anpassbares kapazitives Filterelement (111), ein Sensorelement (113) zum Aufnehmen einer Kenngröße zum Bestimmen einer Induktivität der Drosselspule (109) und ein mit dem anpassbaren Filterelement (111) verbundenes Mikrocontrollerelement (115), wobei das Mikrocontrollerelement (115) eingerichtet ist, in Abhängigkeit der Induktivität der Drosselspule (109) eine Kapazität des anpassbaren kapazitiven Filterelements (111) anzupassen und über die Anpassung der Kapazität eine Sperrfrequenz des Filterelements (111) zu variieren.

Die Erfindung betrifft ferner einen Stromabnehmer (101) mit einer Steuerschaltung (100) und ein elektrisch antreibbares Fahrzeug (200) mit einem Stromabnehmer.

FIG 2

## Beschreibung

Die Erfindung betrifft eine Steuerschaltung für einen Stromabnehmer für ein über eine Oberleitung elektrisch antreibbares Fahrzeug, einen Stromabnehmer und ein elektrisch antreibbares Fahrzeug. Die Erfindung betrifft insbesondere die Anwendung des elektrisch antreibbaren Fahrzeugs im Zusammenhang mit eHighway-Strecken, auf denen über Oberleitungen Fahrzeuge, insbesondere Kraftfahrzeuge, elektrisch antreibbar sind.

Für den elektrischen Antrieb von Kraftfahrzeugen über Oberleitungen ist es essenziell während der Fahrt des Fahrzeugs zu jeder Zeit eine exakte Positionierung des Fahrzeugs unterhalb der Oberleitung zu erreichen, um hierüber eine optimale Stromversorgung des Fahrzeugs zu ermöglichen. Zur Positionierung ist es aus dem Stand der Technik bekannt, LF-Signale über die Oberleitung auszusenden und über entsprechende am Fahrzeug angeordnete Empfänger auszulesen, um basierend auf den LF-Signalen eine Positionsbestimmung des Fahrzeugs relativ zur Oberleitung vorzunehmen. Problematisch ist hierbei jedoch die Steuerschaltung des Stromabnehmers des Fahrzeugs. Diese kann in Abhängigkeit der Frequenz der LF-Signale zu einer starken Dämpfung der Signale und zu einer starken Schwächung der Signalstärke führen, wodurch die Positionierung des Fahrzeugs relativ zur Oberleitung erschwert werden kann.

Der Erfindung liegt die Aufgabe zugrunde, eine verbesserte Steuerschaltung für einen Stromabnehmer für ein über eine Oberleitung elektrisch antreibbares Fahrzeug, einen verbesserten Stromabnehmer und ein verbessertes elektrisch antreibbares Fahrzeug bereitzustellen.

Diese Aufgabe wird durch die Steuerschaltung, den Stromabnehmer und das Fahrzeug der unabhängigen Ansprüche gelöst. Vorteilhafte Ausgestaltungen sind Gegenstand der untergeordneten Ansprüche.

Nach einem Aspekt der Erfindung wird eine Steuerschaltung für einen Stromabnehmer für ein über eine Oberleitung elektrisch antreibbares Fahrzeug bereitgestellt, umfassend einen Stromabnehmer, einen mit dem Stromabnehmer verbundenen Umrichter mit einem Anschlusselement zum Anschließen an einen Antriebsstrang des Fahrzeugs, eine zwischen Stromabnehmer und Umrichter verschaltete Drosselspule, ein parallel zur Drosselspule verschaltetes anpassbares kapazitives Filterelement, ein Sensorelement zum Aufnehmen einer Kenngröße zum Bestimmen einer Induktivität der Drosselspule und ein mit dem anpassbaren Filterelement verbundenes Mikrocontrollerelement, wobei das Mikrocontrollerelement eingerichtet ist, in Abhängigkeit der Induktivität der Drosselspule eine Kapazität des anpassbaren kapazitiven Filterelements anzupassen und über die Anpassung der Kapazität eine Sperrfrequenz des Filterelements zu variieren.

Hierdurch kann der technische Vorteil erreicht werden, dass eine verbesserte Steuerschaltung für einen Stromabnehmer für ein über eine Überleitung elektrisch antreibbares Fahrzeug bereitgestellt werden kann. Die Steuerschaltung ist hierbei eingerichtet, eine Signalschwächung von über die Oberleitung übertragenen niederfrequenten LF-Signalen zu vermeiden. Hierzu weist die Steuerschaltung neben einem Umrichter und einer Drosselspule ein anpassbares Filterelement, ein Sensorelement und ein Mikrocontrollerelement auf. Über das Sensorelement kann eine Kenngröße der Steuerschaltung bzw. der Drosselspule ermittelt werden, über die eine Induktivität der Drosselspule bestimmbar ist. Über das Mikrocontrollerelement kann unter Berücksichtigung der Induktivität der Drosselspule eine Kapazität des anpassbaren kapazitiven Filterelements angepasst werden und über die Anpassung der Kapazität eine Sperrfrequenz des Filterelements variiert werden.

Aus dem Stand der Technik sind Steuerschaltungen für Stromabnehmer für über Oberleitungen elektrisch antreibbare Fahrzeuge bekannt, in denen Drosselspulen verbaut sind, die derart dimensioniert sind, dass bei Ansteuerung des Fahrzeugs, insbesondere unter hoher Last, die Drosselspulen in Sättigung betrieben werden. Dies kann dazu führen, dass insbesondere bei hoher Last, beispielsweise beim Beschleunigen des Fahrzeugs, eine starke Änderung der Induktivität der Drosselspule hervorgerufen wird.

Über die Messung der Induktivität der Drosselspule während des Betriebs des Fahrzeugs über das Sensorelement kann mittels Ansteuerung des anpassbaren kapazitiven Filterelements und durch Anpassung der Kapazität des Filterelements durch das Mikrocontrollerelement die Sperrfrequenz des Filterelements variiert bzw. trotz Änderung der Induktivität der Drosselspule auf einem vorbestimmten Frequenzwert gehalten werden.

Durch das derart anpassbare Filterelement kann somit vermieden werden, dass die über die Oberleitung mit einer vorbestimmten Frequenz übertragenen niederfrequenten LF-Signale durch die Steuerschaltung des Stromabnehmers gedämpft bzw. in ihrer Signalstärke abgeschwächt werden. Hierzu kann die Sperrfrequenz des anpassbar kapazitiven Filterelements auf die Signalfrequenz, der über die Oberleitung zu übertragenden LF-Signale eingestellt werden, um so die Abschwächung bzw. Dämpfung der LF-Signale über die Steuerschaltung vermeiden zu können. Über das Sensorelement können Induktivitätsänderungen der Drosselspule während des Betriebs des Fahrzeugs ermittelt werden und über die Anpassung der Kapazität des kapazitiven Filterelements kann die Sperrfrequenz des Filterelements trotz Änderung der Induktivität der Drosselspule auf dem Wert der Signalfrequenz der über die Oberleitung übertragenen LF-Signale gehalten werden. Trotz der im Betrieb des Fahrzeugs auftretenden Änderungen der Induktivität der Drosselspule kann die Sperrfrequenz des Filterelements auf der Signalfrequenz der über die Oberleitung übertragenen LF-Signale gehalten werden und somit die Dämpfung der LF-Signale durch die Steuerschaltung verhindert werden.

Nach einer Ausführungsform umfasst das Sensorelement einen Stromsensor, wobei das Sensorelement eingerichtet ist, einen Spulenstrom der Drosselspule zu messen.

Hierdurch kann der technische Vorteil erreicht werden, dass eine möglichst einfache und kostengünstige Bestimmung der Induktivität der Drosselspule im Betrieb des Fahrzeugs ermöglicht ist. Über den Stromsensor kann der Spulenstrom der Drosselspule gemessen werden. Über bekannte Kenngrößen der Drosselspule kann auf Grundlage des Spulenstroms die Induktivität der betriebenen Drosselspule berechnet werden.

Nach einer Ausführungsform umfasst das Sensorelement einen Magnetfeldsensor, wobei das Sensorelement eingerichtet ist, ein Spulenmagnetfeld der der Drosselspule zu messen.

Hierdurch kann der technische Vorteil erreicht werden, dass eine einfache und kostengünstige Variante zur Bestimmung der Induktivität der Drosselspule ermöglicht ist. Über die Messung des Spulenmagnetfelds durch den Magnetfeldsensor kann über bekannte Kenngrößen der Drosselspule die Induktivität der Drosselspule im Betrieb ermittelt werden.

Nach einer Ausführungsform ist das Mikrocontrollerelement eingerichtet, basierend auf dem Spulenstrom und/oder dem Spulenmagnetfeld der Drosselspule die Induktivität der Drosselspule zu ermitteln.

Hierdurch kann der technische Vorteil erreicht werden, dass eine einfache Ermittlung der Induktivität der betriebenen Drosselspule unter Berücksichtigung des gemessenen Spulenstroms bzw. des gemessenen Spulenmagnetfelds durch das Mikrocontrollerelement ermöglicht ist.

Nach einer Ausführungsform umfasst das Mikrocontrollerelement eine Datenbank oder ist eingerichtet, auf eine Datenbank zuzugreifen, und wobei in der Datenbank Relationen zwischen Spulenstrom und/oder Spulenmagnetfeld und Induktivität der Drosselspule gespeichert sind.

Hierdurch kann der technische Vorteil erreicht werden, dass eine möglichst einfache Bestimmung der Induktivität der Drosselspule basierend auf dem gemessenen Spulenstrom bzw. dem gemessenen Spulenmagnetfeld ermöglicht ist.

Nach einer Ausführungsform basieren die Relationen zwischen Spulenstrom und/oder Spulenmagnetfeld und Induktivität der Drosselspule auf einem Eich-Prozess der Drosselspule.

Hierdurch kann der technische Vorteil erreicht werden, dass eine möglichst präzise Bestimmung der Induktivität basierend auf dem gemessenen Spulenstrom bzw. dem gemessenen Spulenmagnetfeld ermöglicht ist. Durch den Eich-Prozess, in dem Relationen zwischen Spulenstrom bzw. Spulenmagnetfeld und Induktivität der Drosselspule ermittelt werden, kann basierend auf dem Spulenstrom bzw. Spulenmagnetfeld eindeutig und präzise die tatsächliche Induktivität der betriebenen Drosselspule bestimmt werden.

Nach einer Ausführungsform ist das Mikrocontrollerelement eingerichtet, gemäß der Thomsonschen Schwingungsgleichung $F_{res} = \frac{1}{2\pi\sqrt{L \cdot C}}$ unter Berücksichtigung der Induktivität L der Drosselspule durch Anpassung der Kapazität C des anpassbaren kapazitiven Filterelements eine Resonanzfrequenz $F_{res}$ im Schwingkreis zwischen Drosselspule und Filterelement anzupassen, wobei die Resonanzfrequenz $F_{res}$ der Sperrfrequenz des Filterelements entspricht.

Hierdurch kann der technische Vorteil erreicht werden, dass eine präzise Einstellung der Sperrfrequenz des Filterelements durch das Mikrocontrollerelement unter Berücksichtigung der Induktivität der Drosselspule durch die Anpassung der Kapazität des kapazitiven Filterelements ermöglicht ist. Hierzu wird die Thomsonsche Schwingungsgleichung für Schwingkreise berücksichtigt, die eine Relation zwischen Induktivität eines Spulenelements und Kapazität eines Kondensators zu einer Resonanzfrequenz des Schwingkreises beschreibt. In dem die Sperrfrequenz mit der Resonanzfrequenz des Schwingkreises gleichgesetzt wird, kann durch Variation der Kapazität des Kondensators des Filterelements bei herrschender Induktivität der Drosselspule die Resonanzfrequenz des Schwingkreises auf die gewünschte Sperrfrequenz des Filterelements eingestellt werden. Hierdurch kann präzise die Sperrfrequenz des Filterelements an die bekannte Signalfrequenz der über die Oberleitung übertragenen LF-Signale angepasst werden.

Nach einer Ausführungsform umfasst das anpassbare kapazitive Filterelement wenigstens einen variablen Kondensator, insbesondere einen elektrisch variablen Kondensator, wobei durch Ansteuerung des wenigstens einen variablen Kondensators durch das Mikrocontrollerelement eine Kapazität des Kondensators variierbar ist.

Hierdurch kann der technische Vorteil erreicht werden, dass eine einfache Anpassung der Kapazität des anpassbaren kapazitiven Filterelements ermöglicht ist. Durch Ansteuerung des vorzugsweise elektrisch variablen Kondensators des anpassbaren kapazitiven Filterelements kann die Kapazität des anpassbaren kapazitiven Filterelements durch Ansteuerung durch das Mikrocontrollerelement variiert werden, wodurch die Sperrfrequenz des Filterelements beliebig anpassbar ist.

Nach einer Ausführungsform ist das Sensorelement in den Umrichter integriert.

Hierdurch kann der technische Vorteil erreicht werden, dass eine möglichst platzsparende Steuerschaltung bereitgestellt werden kann. Darüber hinaus kann ein im Umrichter standardmäßig verbautes Sensorelement, beispielsweise ein Stromsensor, für die Messung des Spulenstroms zum Bestimmen der Induktivität der Drosselspule verwendet werden. Ein zusätzliches Sensorelement kann somit vermieden werden. Der Umrichter kann insbesondere als Antriebsumrichter, beispielsweise als DC/DC-Wandler, ausgebildet sein.

Nach einem weiteren Aspekt wird ein Stromabnehmer mit einem Stromabnehmergestell zum Kontaktieren einer Oberleitung und einer Steuerschaltung nach einer der voranstehenden Ausführungsformen bereitgestellt.

Hierdurch kann der technische Vorteil erreicht werden, dass ein verbesserter Stromabnehmer mit einer Steuerschaltung mit den oben beschriebenen technischen Vorteilen bereitgestellt werden kann.

Nach einem weiteren Aspekt wird ein elektrisch antreibbares Fahrzeug mit einem Antriebsstrang zum Antreiben des Fahrzeugs und einem mit dem Antriebsstrang verbundenen erfindungsgemäßen Stromabnehmer zum Kontaktieren einer Oberleitung bereitgestellt.

Hierdurch kann der technische Vorteil erreicht werden, dass ein verbessertes elektrisch antreibbares Fahrzeug mit einem verbesserten Stromabnehmer bereitgestellt werden kann.

Nach einer Ausführungsform ist das Fahrzeug als ein Lastkraftwagen ausgebildet und eingerichtet, auf einer Autobahnstrecke mit Oberleitung zu fahren.

Hierdurch kann der technische Vorteil erreicht werden, dass ein verbesserter elektrisch antreibbarer Lastkraftwagen für eine E-Highway bereitgestellt werden kann.

Die oben beschriebenen Merkmale und Vorteile dieser Erfindung sowie die Art und Weise, wie diese erreicht werden, werden klarer und deutlicher verständlich durch die Erläuterungen der folgenden, stark vereinfachten, schematischen Darstellungen bevorzugter Ausführungsbeispiele. Hierbei zeigen jeweils:

FIG 1    eine schematische Darstellung eines über eine Oberleitung elektrisch antreibbares Fahrzeugs mit einem Stromabnehmer; und

FIG 2    eine schematische Darstellung einer Steuerschaltung für eine Stromabnehmer für ein über eine Oberleitung elektrisch antreibbares Fahrzeug.

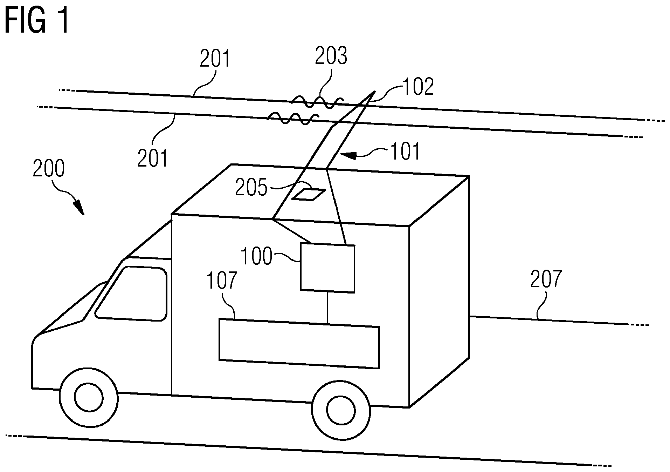

FIG 1 zeigt eine schematische Darstellung eines über eine Oberleitung 201 elektrisch antreibbares Fahrzeugs 200 mit einem Stromabnehmer 101.

FIG 1 zeigt ein über eine Oberleitung 201 elektrisch antreibbares Fahrzeug 200. In der gezeigten Ausführungsform ist das Fahrzeug 200 als ein Kraftfahrzeug, insbesondere als ein Lastkraftwagen (LKW), ausgebildet. Das Fahrzeug 200 umfasst einen Stromabnehmer 101 zum Kontaktieren einer Oberleitung 201. Der Stromabnehmer 101 ist über eine erfindungsgemäße Steuerschaltung 100 für einen Stromabnehmer 101 für ein über eine Oberleitung 201 elektrisch antreibbares Fahrzeug 200 mit einem Antriebsstrang 107 des Fahrzeugs 200 verbunden.

In der gezeigten Ausführungsform ist das Fahrzeug 200 als ein LKW ausgebildet, der auf einem e-Highway gefahren werden kann. Zur Steuerung des Fahrzeugs 200 auf dem e-Highway, bei dem das Fahrzeug 200 die elektrische Energie, über die oberhalb der Fahrbahn 207 angeordnete Oberleitung 201 bezieht, ist es essentiell, dass das Fahrzeug 200 während der Fahrt zu jedem Zeitpunkt optimal unterhalb der Oberleitung 201 positioniert ist. In der gezeigten Ausführung sind zwei parallel zueinander verlaufende Oberleitungen 201 vorgesehen. Der Stromabnehmers 101 wird in der gezeigten Ausführungsform lediglich an die Oberleitung 201 kontaktiert, so dass bei einem Wegsteuern des Fahrzeugs 200 aus der optimalen Kontaktierungsposition, die Kontaktierung zwischen dem Stromabnehmer 101 und den Oberleitungen 201 abgebrochen werden kann.

Um dies zu verhindern, ist aus dem Stand der Technik bekannt, über die Oberleitung 201 niedere frequente LF-Signale 203 auszusenden. Ein am Fahrzeug 200 entsprechend ausgebildetes Empfangselement 205 können die LF-Signale 203 empfangen bzw. ausgelesen werden und hierüber die Positionsbestimmung des Fahrzeugs 200 relativ zur Oberleitung 201 bewirkt werden. Beispielsweise können durch das Empfangselement 205 die elektrischen Felder der LF-Signale 203 ermittelt werden. Bei Kenntnis der Frequenz der LF-Signale 203 kann durch Messung der elektrischen Felder eine relative Positionierung des Fahrzeugs 200 zu den Oberleitungen 201 bewirkt werden.

Die Idee der vorliegenden Erfindung basiert darauf, die erfindungsgemäße Steuerschaltung 100 des Stromabnehmers 101, über die die Verbindung zwischen dem Stromabnehmer 101 und dem Antriebsstrang 107 des Fahrzeugs 200 bewirkt ist, derart auszugestalten, dass eine Dämpfung der über die Oberleitungen 201 übertragenen LF-Signale 203 durch die Steuerschaltung 100 vermieden oder verringert ist.

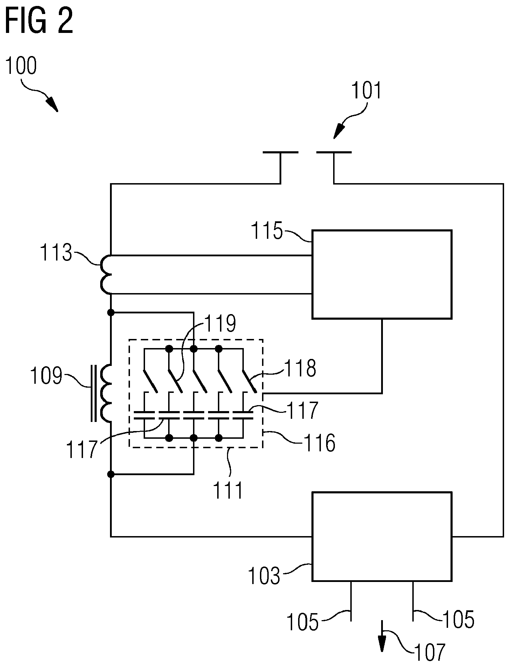

FIG 2 zeigt eine schematische Darstellung einer Steuerschaltung 100 für einen Stromabnehmer 101 für ein über eine Oberleitung 201 elektrisch antreibbares Fahrzeug 200.

In der gezeigten Ausführungsform umfasst die Steuerschaltung 100 den Stromabnehmer 101, einen mit dem Stromabnehmer 101 verbundenen Umrichter 103 und eine zwischen dem Stromabnehmer 101 und dem Umrichter 103 verschaltete Drosselspule 109. Der Umrichter 103 ist über Anschlusselemente 105 mit dem Antriebsstrang 107 des Fahrzeugs 200 verbindbar. Die Steuerschaltung 100 weist ferner ein parallel zur Drosselspule 109 verschaltetes anpassbares kapazitives Filterelement 111 auf. Die Steuerschaltung 100 weist ferner ein Sensorelement 113 auf, mittels dem eine Kenngröße der Steuerschaltung 100 messbar ist, über die eine Induktivität der bestromten Drosselspule 109 im Betrieb des Fahrzeugs ermittelbar ist. Die Steuerschaltung 100 weist ferner ein Mikrocontrollerelement 115 auf, das mit dem anpassbaren kapazitiven Filterelement 111 und dem Sensorelement 113 verbunden ist.

Der Umrichter kann insbesondere als Antriebsumrichter, beispielsweise als DC/DC-Wandler, ausgebildet sein.

Über den Umrichter 103 der Leistungselektronik kann die elektrische Energie der Oberleitungen 201 entweder direkt zum Antreiben des Fahrzeugs 200 in den Antriebsstrang 107 geleitet werden. Alternativ oder zusätzlich kann durch den Umrichter 103 über die elektrische Energie der Oberleitungen 201 eine in Fig. 1 nicht dargestellte Batterieeinheit des Fahrzeugs 200 geladen werden.

Wie oben beschrieben, sind aus dem Stand der Technik Steuerschaltungen 100 mit Drosselspulen 109 bekannt, die aufgrund ihrer geringen Dimensionierung im Betrieb des Fahrzeugs 200, insbesondere unter hoher Last, beispielsweise beim Beschleunigen des Fahrzeugs 200, in Sättigung betrieben werden. Durch den Sättigungsbetrieb der Drosselspule 109 kann die Induktivität der Drosselspule 109 starke Änderungen aufweisen. Durch die Steuerung des anpassbaren kapazitiven Filterelements 111 durch das Mikrocontrollerelement 115 kann eine Kapazität des kapazitiven Filterelements 111 verändert und damit eine Sperrfrequenz des kapazitiven Filterelements 111 angepasst werden. Die Erfindung basiert auf der Idee, dass die Sperrfrequenz des kapazitiven Filterelements 111 der Signalfrequenz, der über die Oberleitungen 201 übertragenen LF-Signale 203 entspricht, so dass eine Dämpfung der LF-Signale 203 durch die Steuerschaltung 100 durch das kapazitive Filterelement 111 unterdrückt bzw. verhindert wird.

Die Erfindung sieht somit vor, dass bei einer Änderung der Induktivität der Drosselspule 109 eine Kapazität des kapazitiven Filterelements 111 derart angepasst wird, dass trotz Änderung der Induktivität der Drosselspule 109 die Sperrfrequenz des Filterelements 111 konstant gehalten werden kann. Hierzu weist das kapazitive Filterelement 111 gemäß der gezeigten Ausführungsform einen variablen Kondensator 116 auf. Bei Ansteuerung des variablen Kondensators 116 durch das Mikrocontrollerelement 115 kann die Kapazität des variablen Kondensators 116 beliebig variiert werden.

Gemäß einer Ausführungsform kann der variable Kondensator 116 beispielsweise als ein aus dem Stand der Technik bekannter elektrisch variabler Kondensator ausgebildet sein.

In der gezeigten Ausführungsform ist der variable Kondensator 116 als eine Kondensatormatrix mit einer Mehrzahl von parallel zueinander verschalteten Kondensatoren 117 und einer Mehrzahl von Schaltelementen 119 ausgebildet. Durch Schalten der Schaltelemente 119 können die Kondensatoren 117 parallel zueinander verschaltet und somit die Gesamtkapazität der Kondensatormatrix bzw. des variablen Kondensators 116 angepasst werden.

In der gezeigten Ausführungsform ist das Sensorelement 113 als ein Stromsensor ausgebildet. Über den Stromsensor kann ein Spulenstrom, der im Betrieb des Fahrzeugs 200 bestromten Drosselspule 109 ermittelt werden. Über den Spulenstrom der bestromten Drosselspule 109 kann eine unter Berücksichtigung von Kenngrößen der Drosselspule 109 die Induktivität der Drosselspule 109 berechnet werden.

Alternativ hierzu kann das Sensorelement 113 als ein Magnetfeldsensor ausgebildet sein oder einen Magnetfeldsensor umfassen. Über den Magnetfeldsensor kann ein Spulenmagnetfeld der bestromten Drosselspule gemessen werden. Über das gemessene Spulenmagnetfeld kann wiederum unter Berücksichtigung von Kenngrößen, wie beispielsweise Windungszahl, der Drosselspule 109 die Induktivität der bestromten Drosselspule ermittelt werden.

Zur Ermittlung der Induktivität der bestromten Drosselspule 109 basierend auf dem gemessenen Spulenstrom bzw. dem gemessenen Spulenmagnetfeld kann das Mikrocontrollerelement 115 eine Datenbank aufweisen bzw. kann eingerichtet sein, auf eine Datenbank zuzugreifen, in der Relationen zwischen dem Spulenstrom bzw. dem Spulenmagnetfeld und der Induktivität der bestromten Drosselspule 109 gespeichert sind. Die gespeicherten Relationen zwischen Spulenstrom bzw. Spulenmagnetfeld und Induktivität können beispielsweise auf einem Eich-Prozess der Drosselspule 109 basieren. Durch Auslesen bzw. Messen des Spulenstroms bzw. des Spulenmagnetfelds kann somit unter Berücksichtigung der Einträge der Datenbank durch das Mikrocontrollerelement 115 eine Induktivität der bestromten Drosselspule 109 bestimmt werden.

Basierend auf der derart ermittelten Induktivität der Drosselspule 109 kann die Kapazität des variierbaren Kondensators 119 des kapazitiven Filterelements 111 derart angepasst werden, dass die Sperrfrequenz des anpassbaren kapazitiven Filterelements 111 auf die Frequenz der LF-Signale 203 eingestellt wird.

Hierzu kann beispielsweise die Thomsonsche Schwingungsgleiche für Schwingkreise berücksichtigt werden, in der eine Relation zwischen Induktivität L eines Spulenelements und Kapazität C eines Kondensators zur Resonanzfrequenz $F_{res}$ des Schwingungskreises beschrieben ist. Indem die Resonanzfrequenz $F_{res}$ der Sperrfrequenz des Filterelements 111 gleichgesetzt ist, kann bei einer gegebenen Induktivität L der Drosselspule 109 durch entsprechendes Ansteuern des variierbaren Kondensators 116 die entsprechende Kapazität C des Kondensators 116 derart angepasst werden, dass die gewünschte Sperrfrequenz des Filterelements 111 erreicht werden kann.

$$F_{res} = \frac{1}{2\pi\sqrt{L \cdot C}}$$

Abweichend von der in FIG 2 gezeigten Ausführungsform kann das Sensorelement 113 an einer beliebigen Stelle innerhalb der Steuerschaltung 100 angeordnet sein. Beispielsweise kann das Sensorelement 113 im Umrichter 103 verbaut sein. Beispielsweise kann als Sensorelement 113 ein standardmäßig im Umrichter 103 verbauter Stromsensor verwendet werden, so dass kein zusätzliches Sensorelement 113 in der Steuerschaltung verbaut werden muss.

Die Anzahl bzw. Anordnung der Kondensatoren 117 der Kondensatormatrix des variierbaren Kondensators 116 in FIG 2 ist lediglich beispielhaft und soll die vorliegende Erfindung nicht einschränken.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Steuerschaltung (100) für einen Stromabnehmer (101) für ein über eine Oberleitung (201) elektrisch antreibbares Fahrzeug (200), umfassend einen Stromabnehmer (101), einen mit dem Stromabnehmer (101) verbundenen Umrichter (103) mit einem Anschlusselement (105) zum Anschließen an einen Antriebsstrang (107) des Fahrzeugs (200), eine zwischen Stromabnehmer (101) und Umrichter (103) verschaltete Drosselspule (109), ein parallel zur Drosselspule (109) verschaltetes anpassbares kapazitives Filterelement (111), ein Sensorelement (113) zum Aufnehmen einer Kenngröße zum Bestimmen einer Induktivität der Drosselspule (109) und ein mit dem anpassbaren Filterelement (111) verbundenes Mikrocontrollerelement (115), wobei das Mikrocontrollerelement (115) eingerichtet ist, in Abhängigkeit der Induktivität der Drosselspule (109) eine Kapazität des anpassbaren kapazitiven Filterelements (111) anzupassen und über die Anpassung der Kapazität eine Sperrfrequenz des Filterelements (111) zu variieren.

2. Steuerschaltung (100) nach Anspruch 1, wobei das Sensorelement (113) einen Stromsensor umfasst, und wobei das Sensorelement (113) eingerichtet ist, einen Spulenstrom der Drosselspule (109) zu messen.

3. Steuerschaltung (100) nach Anspruch 1 oder 2, wobei das Sensorelement (113) einen Magnetfeldsensor umfasst, und wobei das Sensorelement (113) eingerichtet ist, ein Spulenmagnetfeld der der Drosselspule (109) zu messen.

4. Steuerschaltung (100) nach Anspruch 2 oder 3, wobei das Mikrocontrollerelement (115) eingerichtet ist, basierend auf dem Spulenstrom und/oder dem Spulenmagnetfeld der Drosselspule (109) die Induktivität der Drosselspule (109) zu ermitteln.

5. Steuerschaltung (100) nach Anspruch 4, wobei das Mikrocontrollerelement (115) eine Datenbank umfasst oder eingerichtet ist, auf eine Datenbank zuzugreifen, und wobei in der Datenbank Relationen zwischen Spulenstrom und/oder Spulenmagnetfeld und Induktivität der Drosselspule (109) gespeichert sind.

6. Steuerschaltung (100) nach Anspruch 5, wobei die Relationen zwischen Spulenstrom und/oder Spulenmagnetfeld und Induktivität der Drosselspule auf einem Eichprozess der Drosselspule (109) basieren.

7. Steuerschaltung (100) nach einem der voranstehenden Ansprüche, wobei das Mikrocontrollerelement (115) eingerichtet ist, gemäß der Thomsonschen Schwingungsgleichung $F_{res} = \frac{1}{2\pi\sqrt{L \cdot C}}$ unter Berücksichtigung der Induktivität L der Drosselspule (109) durch Anpassung der Kapazität C des anpassbaren kapazitiven Filterelements eine Resonanzfrequenz $F_{res}$ im Schwingkreis zwischen Drosselspule (109) und Filterelement anzupassen, wobei die Resonanzfrequenz $F_{res}$ der Sperrfrequenz des Filterelements (111) entspricht.

8. Steuerschaltung (100) nach einem der voranstehenden Ansprüche, wobei das anpassbare kapazitive Filterelement (111) wenigstens einen variablen Kondensator (116), insbesondere einen elektrisch variablen Kondensator (116), umfasst, und wobei durch Ansteuerung des wenigstens einen variablen Kondensators (116) durch das Mikrocontrollerelement (115) eine Kapazität des Kondensators (116) variierbar ist.

9. Steuerschaltung (100) nach einem der voranstehenden Ansprüche, wobei das Sensorelement (113) in den Umrichter (103) integriert ist.

10. Stromabnehmer (101) mit einem Stromabnehmergestell (102) zum Kontaktieren einer Oberleitung (201) und einer Steuerschaltung (100) nach einem der voranstehenden Ansprüche 1 bis 9.

11. Elektrisch antreibbares Fahrzeug (200) mit einem Antriebsstrang (107) zum Antreiben des Fahrzeugs (200) und einem mit dem Antriebsstrang (107) verbundenen Stromabnehmer (101) nach Anspruch 10 zum Kontaktieren einer Oberleitung (201) .

12. Elektrisch antreibbares Fahrzeug (200) nach Anspruch 11, wobei das Fahrzeug (200) als ein Lastkraftwagen ausgebildet und eingerichtet ist, auf einer Autobahnstrecke mit Oberleitung (201) zu fahren.

# FIG 1

FIG 2

Europäisches
Patentamt

European
Patent Office

Office européen
des brevets

# EUROPÄISCHER RECHERCHENBERICHT

Nummer der Anmeldung

**EP 23 16 4642**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | EP 3 848 229 A1 (VOLKSWAGEN AG [DE]) 14. Juli 2021 (2021-07-14) | 1-3,7-12 | INV. G01R19/00 |
| A | * Absatz [0001]; Abbildung 2 * ----- | 4-6 | G08B29/00 H04B3/54 |
| Y | US 2010/164295 A1 (ICHIKAWA KATSUEI [JP] ET AL) 1. Juli 2010 (2010-07-01) | 1-3,7-12 | B60L5/18 B60L53/20 |
| A | * Absatz [0014]; Abbildung 9 * ----- | 4-6 | B60L3/12 B60L9/00 B60L9/18 |

**RECHERCHIERTE SACHGEBIETE (IPC)**

G01R
H04B
G08B
B60L

Der vorliegende Recherchenbericht wurde für alle Patentansprüche erstellt

| Recherchenort | Abschlußdatum der Recherche | Prüfer |
|---|---|---|
| Den Haag | 19. Oktober 2023 | Wirth, Sebastian |

**ANHANG ZUM EUROPÄISCHEN RECHERCHENBERICHT
ÜBER DIE EUROPÄISCHE PATENTANMELDUNG NR.**

EP 23 16 4642

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-10-2023

| Im Recherchenbericht angeführtes Patentdokument | Datum der Veröffentlichung | Mitglied(er) der Patentfamilie | Datum der Veröffentlichung |
|---|---|---|---|
| EP 3848229 A1 | 14-07-2021 | CN 113103879 A | 13-07-2021 |
| | | DE 102020200300 A1 | 29-07-2021 |
| | | EP 3848229 A1 | 14-07-2021 |
| US 2010164295 A1 | 01-07-2010 | CN 101771297 A | 07-07-2010 |
| | | JP 5135204 B2 | 06-02-2013 |
| | | JP 2010154700 A | 08-07-2010 |
| | | US 2010164295 A1 | 01-07-2010 |

EPO FORM P0461

Für nähere Einzelheiten zu diesem Anhang : siehe Amtsblatt des Europäischen Patentamts, Nr.12/82